# EUROPEAN PATENT APPLICATION

(11) **EP 4 571 326 A1**
(43) Date of publication of application: **18.06.2025**
(21) Application number: 23216835.1
(22) Date of filing: 14.12.2023
(51) Int. Cl.: G01R 19/00, H02M 1/00, H03F 3/217, G01R 19/165, G01R 19/10

(54) **CURRENT DETECTION IN HALF-BRIDGE CIRCUIT**

(71) Applicant: ICEpower a/s, 2860 Søborg (DK)
(72) Inventor: NIELSEN, Ole Neis, 2765 Smørum (DK); BOSTRÖM, Patrik, 256 57 Ramlösa (SE)
(74) Representative: Lind Edlund Kenamets Intellectual Property AB

(57) **Abstract**

A circuitry for detecting an output current of a half-bridge circuit, comprising a first current detection element arranged between the high-side switch and the high voltage rail, a second current detection element arranged between the low-side switch and the low voltage rail, and a summation point connected to provide an output signal equal to the sum of the currents detected by the first and second current detection elements. The output signal is indicative of the output current of the half-bridge circuit.

With this approach, a reliable measurement of the output current is achieved at low cost, and without significant power loss. A further benefit is that any shot though current is cancelled out.

## Description

### Field of the invention

The present invention relates to current detection in half-bridge circuits and advantageous applications of such current detection.

### Background of the invention

Current detection is required in various situations, including current feedback control and current limitation circuitry. There are several ways to measure current, but they are typically associated with specific drawbacks.

A straight-forward current detection is to measure the voltage drop across a shunt resistor. This approach has the obvious drawback of power loss, making it less appropriate in many applications.

A less "invasive" current detection can be achieved with Hall effect sensors. This approach is useful in a wide variety of applications, including Class D feedback control. However, Hall effect sensors are relatively expensive, making this approach incompatible with many low-cost implementations.

One specific area, where current detection is critical, is current limitation. In many amplifier applications, it is desirable to reduce the size of the coil on the output side, and preferably use a cost-effective air-gap coil. However, such a coil cannot handle any significant current overshoot. Therefore, precise current limitation becomes very important.

### General disclosure of the invention

It is an object with the present invention to provide current detection mitigating some of the mentioned drawbacks, specifically for use in a half-bridge circuit. In particular, the present invention seeks to provide a low-cost and non-invasive current detection in a half-bridge circuit.

According to a first aspect of the invention, this and other objects are achieved by a circuitry for detecting an output current of a half-bridge circuit, the half-bridge circuit including a high-side switch and a low-side switch connected in series between a high voltage supply rail and a low voltage supply rail, and an output terminal between the high-side and low-side switch, which output terminal in use delivers the output current. The current detection circuitry comprises a first current detection element arranged between the high-side switch and the high voltage rail and configured to provide a first current detection signal indicative of a high-side current, a second current detection element arranged between the low-side switch and the low voltage rail and configured to provide a second current detection signal indicative of a low-side current, and a summation point having a first input terminal connected to receive the first current detection signal, a second input terminal connected to receive the second current detection signal, and an output terminal providing an output signal equal to the sum of the first and second current detection signals, the output signal being indicative of the output current of the half-bridge circuit.

A measure of the output current is thus obtained by a "double" current detection, one on the high side and one on the low side. A measure of the output current can then be obtained as a sum of these measures (assuming that the two currents are measured with the same reference direction).

With this approach, a reliable measurement of the output current is achieved at low cost, and without significant power loss. A further benefit is that any shoot though current is cancelled out.

The invention is applicable in both single ended (SE) applications and bridge tied load (BTL) applications.

The high voltage and low voltage rails can have positive and negative voltages with respect to the ground potential of the system (referred to as a split supply system). Alternatively, the low voltage rail is grounded (referred to as a single supply system).

The current detection elements may comprise resistors connected in series between respective switch and rail, and a voltage source configured to generate a voltage signal proportional to a voltage difference across the resistor.

The current detection approach of the first aspect may be advantageous in many applications.

In some applications, the current detection circuitry according to the first aspect is implemented in a self-oscillating current limitation loop in a switching power conversion system, wherein a control loop of the power conversion is overruled when the detected output current exceeds a predefined threshold.

Consequently, a second aspect of the invention relates to a switching power conversion system comprising a comparator configured to compare a feedback signal with an input voltage to provide a PWM signal, a switching stage connected to receive the PWM signal and to provide a switching output, and a self-oscillating current limitation loop. The self-oscillating current limitation loop includes current detection circuitry according to the first aspect, and disabling circuitry for disabling the switching stage when the detected output is outside a predefined range (high cut-off and low cut-off).

In prior art using peak current detection (at either side of the half-bridge), the average output current will depend on the switching frequency, as the ripple current will increase inversely proportional to the switching frequency (lower frequency -> longer period -> greater current increase). Current detection according to the present invention will not depend on the switching frequency.

Another advantage is the current measurement signal has no spikes caused by the charging of the switches. Such "overshoot" current spikes will have opposite signs in the summation point and are therefore cancelled. As a consequence, less filtering of the measurement signal is required, which in turn leads to a faster reaction and less over-shoot.

The disabling circuitry may comprise a hysteresis comparator for comparing the detected output current with the high cut-off and low cut-off of the predefined range, and the disabling circuitry may then be configured to selectively disable the switching stage when the detected output current is outside the predefined range.

The hysteresis will be symmetrical around the cutoff current, and the resulting current will therefore equal the average current.

In some embodiments, the disabling circuitry may be configured to selectively invert the PWM signal before it is supplied to the switching stage when the detected output current is outside the predefined range.

In some embodiments, the current detection circuitry according to the first aspect is implemented in a current controlled self-oscillating modulator (CCOM),

Such a modulator (CCOM) is disclosed e.g. in WO02/25357, hereby incorporated by reference. The CCOM approach has not been widely used, and one reason is that the current has been considered difficult to measure in an appropriate manner. By implementing current detection according to the first aspect of the present invention, the CCOM approach becomes more attractive.

### Brief description of the drawings

The present invention will be described in more detail with reference to the appended drawings, showing currently preferred embodiments of the invention.
Figure 1 shows a switching power conversion system with a current detection circuit according to an embodiment of the present invention.
Figure 2 shows a switching power conversion system with a disabling current limitation circuit according to an embodiment of the present invention.
Figure 3a-b show two examples of a switching power conversion system with an active current limitation circuit according to embodiments of the present invention.
Figure 4 shows a switching power conversion system with an active current limitation circuit according to a further embodiment of the present invention.
Figure 5 shows a switching power conversion system with a current-controlled self-oscillating modulator according to an embodiment of the present invention.

### Detailed description of preferred embodiments

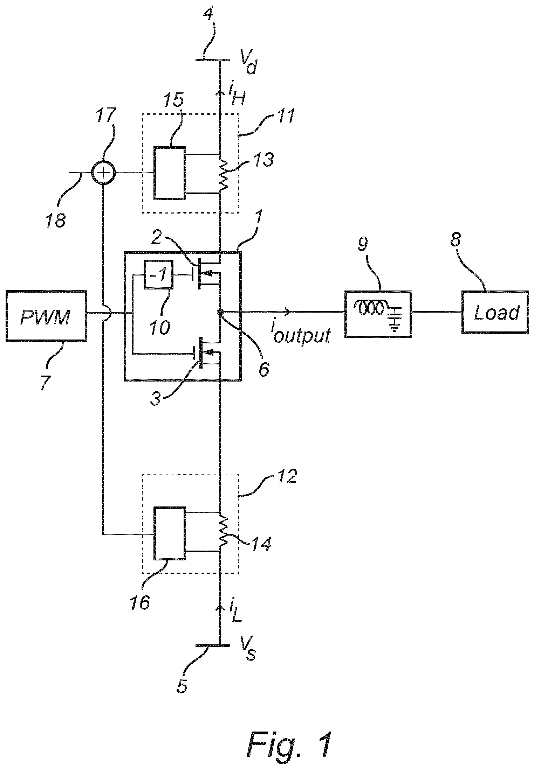

The switching power conversion system in figure 1 includes a half-bridge driver circuit 1 having two switches 2, 3; a high-side switch 2, connected between a high voltage rail 4 and an output terminal 6, and a low-side switch 3 connected between a low voltage rail 5 and the output terminal 6. In the illustrated example, the high voltage rail 4 is held at a potential Vd, higher than ground, while the low voltage rail 5 is held at a potential Vs, lower than ground. This type of voltage supply is referred to as a split supply.

The switches 2, 3 are here illustrated as MOSFETs, but may alternatively be another type of switches, including other types of field effect transistors (FETs) or bipolar transistors such as BJTs or IGBTs. The half-bridge driver circuit 1 is driven by a pulse width modulator (PWM) 7, which could be a controlled oscillation modulator (COM) known in the art. The output of the modulator 7 (PWM signal) is provided to the gates of each switch 2, 3 respectively. If the switches 2 and 3 are of the same kind (e.g. N-channel MOSFETs) the drive signal to one of the switches is inverted by an inverter 10.

The output terminal 6 of the half-bridge driver 1 is connected to a load 8, preceded by a modulation filter 9 comprising a coil and a capacitor connected to ground. In operation, the drive signal from the controller will open one switch and close the other switch, causing an output current *iₒᵤₜₚᵤₜ* to flow through the filter 9 and load 8.

The current detection circuitry in figure 1 includes a high-side current detection element 11 and a low-side current detection element 12. Each current detection element 11, 12 here includes a resistor 13, 14, connected in series between the respective switch 2, 3 and voltage rail 4, 5, and a voltage source 15, 16 configured to provide a voltage signal indicative of the voltage across the resistor 13, 14 (and thus indicative of the current *i_{H}*, *i_{L}* through each resistor 13, 14. The two voltage signals are connected to the input terminals of a summation point 17, and the output terminal 18 of the summation point 17 provides a signal indicative of the output current *iₒᵤₜₚᵤₜ* equal to the sum of the currents *i_{H}* and *i_{L}*.

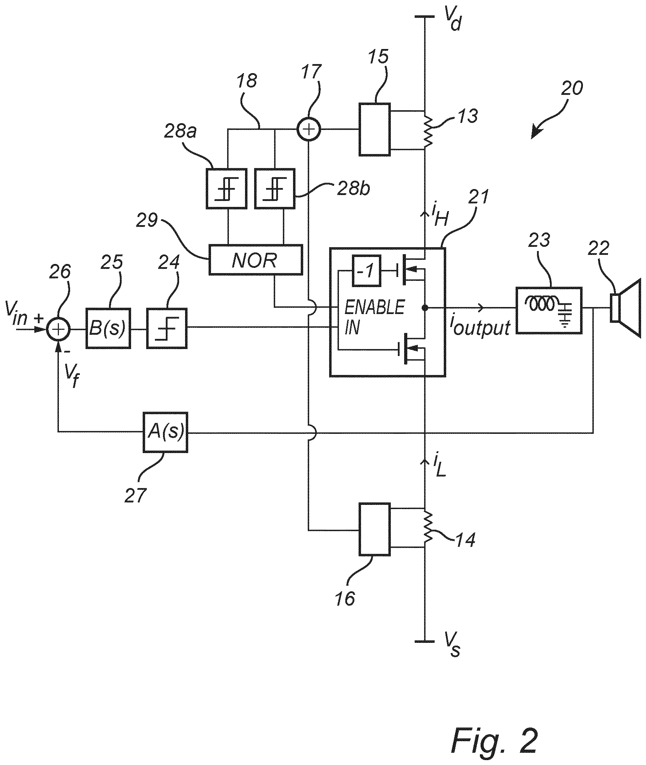

Figure 2 shows a Class-D audio amplifier 20 with a self-oscillating modulator. The amplifier has a current limitation based on a current detection using the circuitry in figure 1.

The amplifier 20 generally includes a half-bridge switching stage 21, similar to circuit 1 in figure 1. The switching output is connected to a loudspeaker 22 via a demodulation filter 23.

The drive signal for the switching stage 21 is here provided by a comparator 24, which is connected to the output of a forward block 25, having a transfer function B(s). The forward block 25 is connected to the output of a summing point 26, which provides an output signal equal to the difference between an audio input signal *vᵢₙ* and a feedback signal *v_{f}.* The feedback signal *v_{f}* is the output of a feedback path 27, connected to the output of the demodulation filter 23. The feedback path 27 has a transfer function A(s).

In this embodiment, the switching stage has an "enable" gate, which serves to set the switching stage in an active state or a disabled state.

The current limiting circuitry includes a current detection circuit as shown in figure 1. As discussed with reference to figure 1, the circuit includes resistors 13, 14, voltage sources 15, 16 and a summation point 17. The output signal 18 from the summation point 17, is indicative of the output current *iₒᵤₜₚᵤₜ.*

The output signal 18 is connected to two hysteresis comparators 28a, 28b, which compare the signal 18 with a low cut-off and a high cut-off, respectively. The first comparator 28a provides a HIGH output if the signal 18 is below the lower limit, while the second comparator 28b provides a HIGH output if the signal 18 is above an upper limit. The two outputs are connected to a logic NOR gate 29, such that the output of the NOR gate 29 will be HIGH if and only if both outputs of the comparators 28a, 28b are LOW, indicating that the signal 18 is within the limits. A HIGH output from the NOR gate 29 will enable the switching stage 21.

In operation, as long as the output of gate 29 is HIGH the amplifier 20 operates in a conventional manner as a self-switching class-D amplifier with global feedback. The output current Iₒᵤₜₚᵤₜ is measured by the circuitry 13, 14, 15, 16, 17 and the measurement signal is supplied to the hysteresis comparator 28. If the signal 18 from the summation point 17 is outside a predefined voltage range - representing a desired cut-off current - one of the outputs of the comparators 28a, 28b will turn HIGH, and the output of the NOR gate 29 will turn LOW. As a result, the switching stage 21 will be disabled.

The hysteresis in the comparators 28a, 28b causes self-oscillation in the current control loop. The skilled person will understand that there are many other ways to achieve such self-oscillation. Other alternatives include:
1. A fixed OFF time, where the switching circuitry 21 is disabled for a fixed amount of time every time the signal 18 exceeds a given limit,
2. high-frequency poles in the feedback loop, e.g. provided by a transfer function between the summation point 17 and the enable terminal,
3. a delay in the feedback path between the summation point 17 and a comparator connected to the enable terminal.

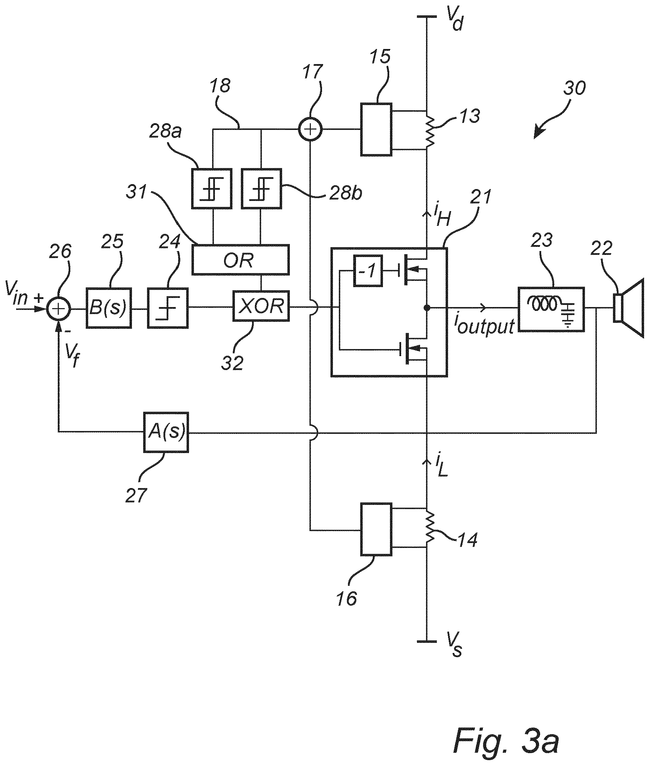

Figure 3a-b show an "active" control of the switching circuit 21, i.e., without an "enable" terminal. Instead, the PWM signal from the comparator 24 is manipulated before it is supplied to the switching circuit 21.

The system 30 in figure 3a, again has two hysteresis comparators 28a, 28b (identical to those in figure 2) connected to the output signal 18. The outputs of the comparators are connected to an OR gate 31. The output of the OR gate 31 is connected to an XOR gate 32, which also receives the PWM signal from the comparator 24. The output of the XOR gate is connected to the switching stage 21.

With this design, if the signal 18 is within the limits, both comparators will be LOW, and the OR gate will also be LOW. As a result, the output of the XOR gate 32 will be equal to the PWM signal. However, as soon as any one of the comparators 28a, 28b turn HIGH (signal 18 outside the limits) the output from the OR gate 31 will be HIGH. In this case, the PWM signal will be reversed by the XOR gate 32.

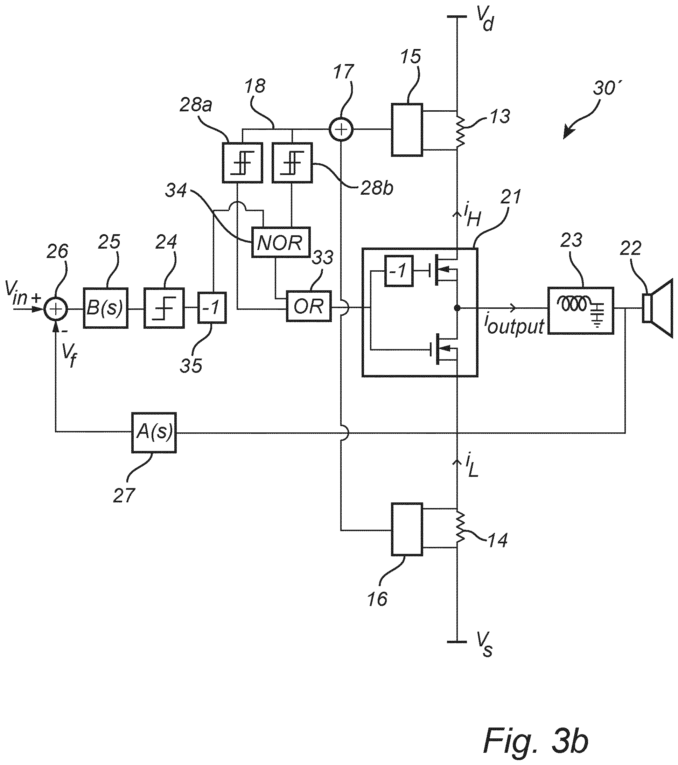

The system 30' in figure 3b again has two hysteresis comparators 28a, 28b (identical to those in figure 2) connected to the output signal 18. The output of first comparator 28a (lower limit) is connected to a first input of an OR gate 33. The second input of the OR gate 33 is connected to the output of a NOR gate 34. The first input of the NOR gate 34 is connected to the output of the second comparator 28b (upper limit), while the second input of the NOR gate 34 is connected to the PWM signal via an inverter 35.

The function of the system 30' in figure 3b is similar to that of system 30 in figure 3a. In both examples, a signal 18 within the limits (both comparators 28a, 28b LOW) will allow the PWM signal to reach the switching stage. However, as soon as one of the comparators 28a, 28b turns HIGH, the PWM signal will be reversed.

Compared to the system 30 in figure 3a, the system 30' in figure 3b will actively gate away any influence from the forward path 24, 25, thereby providing a more robust operation.

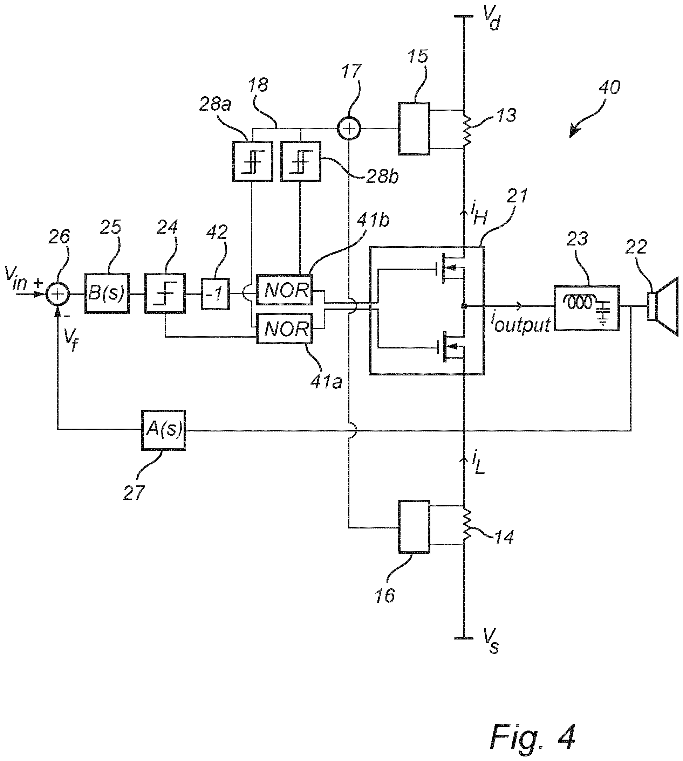

Figure 4 shows another example of a system 40 with current limitation by "active" PWM control. In the circuit in figure 4, the switching stage 21 is a dual input switching stage, i.e., it has a first input (HI) controlling the high side switch and a second input (LO) controlling the low side switch.

Just as in figures 3a/3b the signal 18 is connected to two hysteresis comparators 28a, 28b. Further, two NOR gates 41a, 41b are connected to the LO and HI inputs of the switching stage, respectively. A first input of the first NOR gate 41a (LO side) is connected to the output of the first comparator 28a, while the second input of the first NOR gate 41a is connected to the PWM signal. A first input of the second NOR gate 41b (HI side) is connected to the output of the second comparator 28b, while the second input of the second NOR gate 41b is connected to the PWM signal via an inverter 42.

With this design, the LO input of the switching stage 21 will receive a HIGH signal if and only if the PWM signal is LOW and the signal 18 is above the lower limit. Further, the HI input of the switching stage 21 will receive a HIGH signal if and only if the PWM signal is HIGH and the signal 18 is below the upper limit.

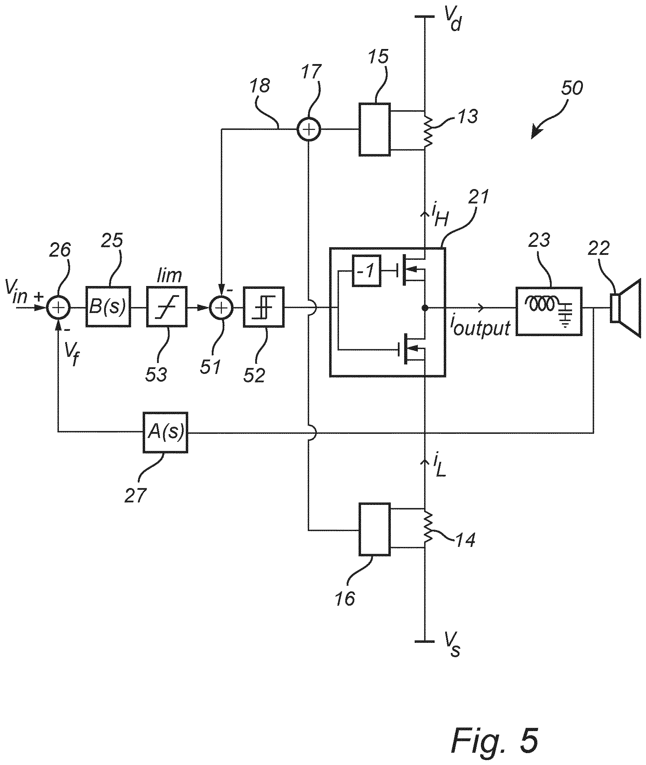

Figure 5 shows a half-bridge power converter 50 connected to a loudspeaker 22 preceded by a modulation filter 23. The power converter 50 includes a hysteresis comparator 52 connected to provide a PWM signal to a switching stage 21. Similar to figure 2, 3a, 3b and 4, a feedback path connected to the output of the filter 23 includes a feedback transfer function A(s) 27, and provides a feedback signal to a summation point 26, where it is subtracted from an input voltage signal *vᵢₙ.* The resulting error signal is provided to a forward path transfer function B(s) 25.

In addition to this "global" feedback, the converter in figure 5 further comprises a local current feedback path. The current feedback path includes a current detection circuit 11, 12, 17 as shown in figure 1. As discussed with reference to figure 1, the circuit includes current detection elements 11, 12 (i.e. resistors 13, 14 and voltage sources 15, 16) and a summation point 17. The current detection circuit is configured to detect the output current *iₒᵤₜₚᵤₜ* by measuring and summing the high side current *i_{H}* and the low side current *i_{L}*.

The output signal 18 from the summation point 17, indicative of the output current *iₒᵤₜₚᵤₜ,* is provided to a summation point 51, where it is deducted from the output from the forward path transfer function 25. The output from the summation point 51 is connected to the hysteresis comparator 52. The hysteresis in the comparator will cause self-oscillation of the current feedback loop, and this is therefore referred to as a current controlled oscillating modulator (CCOM) which was described in WO02/25357.

As discussed in WO02/25357, self-oscillation can also be caused without any hysteresis in the comparator 52. In that case, a transfer function of the current feedback path (or possibly in the forward path between the summation point and the comparator) is designed to cause self-oscillation. This can be accomplished e.g. by means of high frequency poles or a suitable lag.

The person skilled in the art realizes that the present invention by no means is limited to the preferred embodiments described above. On the contrary, many modifications and variations are possible within the scope of the appended claims. For example, the current detection elements 11 and 12 may be implemented in various ways.

## Claims

1. A current detection circuitry for detecting an output current of a half-bridge circuit (1; 21), the half-bridge circuit (1, 21) including a high-side switch (2) and a low-side switch (3) connected in series between a high voltage supply rail (4) and a low voltage supply rail (5), and an output terminal (6) between the high-side and low-side switch (2, 3), which output terminal (6) in use delivers the output current, *iₒᵤₜₚᵤₜ,* the current detection circuitry (11, 12, 17) comprising:
a first current detection element (11; 13, 15) arranged between the high-side switch (2) and the high voltage supply rail (4) and configured to provide a first current detection signal indicative of a high-side current, *i_{H}*,
a second current detection element (12; 14, 16) arranged between the low-side switch (3) and the low voltage supply rail (5) and configured to provide a second current detection signal indicative of a low-side current *i_{L}*, and
a summation point (17) having a first input terminal connected to receive the first current detection signal, a second input terminal connected to receive the second current detection signal, and an output terminal providing an output signal (18) equal to the sum of the first and second current detection signals, the output signal (18) being indicative of the output current, *iₒᵤₜₚᵤₜ,* of the half-bridge circuit (1; 21).

2. The current detection circuitry according to claim 1, wherein the high voltage supply rail (4) has a positive voltage with respect to a ground potential of the circuitry (1; 21), and the low voltage supply rail (5) has a negative voltage with respect to the ground potential of the circuitry (1; 21).

3. The current detection circuitry according to claim 1, wherein the low voltage supply rail is grounded.

4. The current detection circuitry according to claim 1, wherein the first current detection element (11) comprises a high-side resistor (13) connected in series between the high-side switch (2) and the high voltage supply rail (4) and a first voltage source (15) configured to generate a voltage signal proportional to a voltage difference across the high-side resistor (13), and wherein the second current detection element (12) comprises a low-side resistor (14) between the low-side switch (3) and the low voltage supply rail (5) and a second voltage source (16) configured to generate a voltage signal proportional to a voltage difference across the low-side resistor (14).

5. A switching power conversion system (20) comprising:
a comparator (24) configured to compare a feedback signal with an input voltage to provide a PWM signal,
a switching stage (21) connected to receive the PWM signal and to provide a switching output, and
a self-oscillating current limitation loop, said self-oscillating current limitation loop including:
current detection circuitry (11, 12, 17) according to one of the preceding claims, and
disabling circuitry (28a, 28b, 29) for disabling the switching stage when the detected output current is outside a predefined range.

6. The switching power conversion system according to claim 5, wherein the disabling circuitry comprises a hysteresis comparator (28a, 28b, 29) for comparing the detected output current with the predefined range, and wherein the disabling circuitry is configured to disable the switching stage in dependence of the output of the hysteresis comparator (28a, 28b, 29).

7. The switching power conversion system according to claim 5, wherein the disabling circuitry comprises a non-hysteresis comparator for comparing the detected output current with a predefined range, and wherein the disabling circuitry is configured to disable the switching stage in dependence of the output of the hysteresis comparator and keeping the switching stage disabled for a pre-set off-time.

8. The switching power conversion system according to claim 5, wherein the disabling circuitry comprises circuitry (28a, 28b, 31, 32; 28a, 28b, 33, 34, 35; 28a, 28b, 41a, 41b, 42) for selectively inverting the PWM signal before it is supplied to the switching stage (21) when the detected output current is outside the predefined range.

9. The switching power conversion system according to one of claims 5-8, used as an audio amplifier.

10. A current controlled self-oscillating modulator (CCOM) comprising a current feedback path including a current detection circuitry (11, 12, 17) according to one of claims 1-4.

11. A switching power conversion system (50) comprising a modulator according to claim 10.

12. The switching power conversion system (50) according to claim 11, further comprising a feedback path from the output of a demodulation filter, including a feedback transfer function A(s) (27).
